# EUROPÄISCHE PATENTSCHRIFT

(11) **EP 1 204 776 B1**
(45) Veröffentlichungstag und Bekanntmachung des Hinweises auf die Patenterteilung: **02.06.2004**
(21) Anmeldenummer: 00956264.6
(22) Anmeldetag: 24.07.2000
(51) Int. Cl.: C22C 19/05, C30B 11/00

(54) **HOCHTEMPERATURBESTÄNDIGES BAUTEIL UND VERFAHREN ZUR HERSTELLUNG DES HOCHTEMPERATURBESTÄNDIGEN BAUTEILS**
HIGH-TEMPERATURE PART AND METHOD FOR PRODUCING THE SAME
PIECE RESISTANT A DES TEMPERATURES ELEVEES ET SON PROCEDE DE PRODUCTION

(30) Priorität: 29.07.1999 EP 99114278
(43) Veröffentlichungstag der Anmeldung: 15.05.2002
(73) Patentinhaber: SIEMENS AKTIENGESELLSCHAFT, 80333 München (DE); DONCASTERS Precision Castings-Bochum GmbH, 44793 Bochum (DE)
(72) Erfinder: HERMANN, Wolfgang, D-45479 Mülheim (DE); ESSER, Winfried, D-44805 Bochum (DE); SINGER, Robert, D-91054 Erlangen (DE); VOLEK, Andreas, D-91056 Erlangen (DE); GROSSMANN, Jörn, D-45325 Hattingen (DE); BÜRGEL, Ralf, D-49324 Melle (DE); SCHOLZ, Alfred, D-64354 Reinheim (DE); PYCZAK, Florian, D-91054 Buckenhof (DE); PREUHS, Jürgen, D-46047 Oberhausen (DE); MUGHRABI, Hael, D-91054 Buckenhof (DE)
(74) Vertreter: Berg, Peter, Dipl.-Ing.
(86) Internationale Anmeldenummer: PCT/EP2000/007079
(87) Internationale Veröffentlichungsnummer: WO 2001/009403

(56) Entgegenhaltungen:
- US-A- 5 611 670
- PATENT ABSTRACTS OF JAPAN vol. 1997, no. 10, 31. Oktober 1997 (1997-10-31) -& JP 09 157777 A (MITSUBISHI MATERIALS CORP), 17. Juni 1997 (1997-06-17)

## Beschreibung

Die Erfindung betrifft ein hochtemperaturbeständiges Bauteil aus einer Nickel-Basis-Superlegierung. Die Erfindung betrifft auch ein Verfahren zur Herstellung des Bauteils.

In der DE 23 33 775 B2 ist ein Verfahren zur Wärmebehandlung einer Nickellegierung beschrieben. Die Nickellegierung besteht aus bis zu 0,3 % Kohlenstoff, 11-15 % Chrom, 8-12 % Kobalt, 1-2,5 % Molybdän, 3-10 % Wolfram, 3,5-10 % Tantal, 3,5-4,5 % Titan, 3-4 % Aluminium, 0,005-0,025 % Bor, 0,05-0,4 % Zirkon und den Rest Nickel. Weiterhin sind 0,01-3 % Hafnium zusätzlich in der Legierung enthalten, wobei durch eine geeignete Wärmebehandlung eine blockartige Carbid-Ausbildung und eine feindisperse Ausscheidung einer Ni₃(Al,Ti)-Phase. Ein Zusatz von Rhenium oder Ruthenium wird nicht angesprochen.

Die US-PS-5,611,670 offenbart eine Laufschaufel für eine Gasturbine. Die Laufschaufel weist einen einkristallinen Plattformbereich und ein einkristallines Schaufelblatt auf. Ein Befestigungsbereich der Schaufel ist mit einer gerichtet erstarrten Struktur ausgeführt. Die Schaufel ist aus einer Superlegierung gegossen, die in Gewichtsprozent folgende Zusammensetzung aufweist: bis zu 0,2 % Kohlenstoff, 5-14 % Chrom, 4-7 % Aluminium, 2-15 %Wolfram, 0,5-5 % Titan, bis zu 3 % Niob, bis zu 6 % Molybdän, bis zu 12 % Tantal, bis zu 10,5 % Kobalt, bis zu 2 % Hafnium, bis zu 4 % Rhenium, bis 0,035 % Bor, bis zu 0,035 % Zirkon und den Rest Nickel. Diese weiten Bereichsangaben dienen der Angabe von Legierungszusammensetzungen, die grundsätzlich für die vorgeschlagene Gasturbinenschaufel geeignet sind, zeigen aber keinen hinsichtlich einer besonderen Oxidations- und Korrosionsbeständigkeit oder Festigkeit geeigneten Zusammensetzungsbereich auf.

In der EP 0 297 785 B1 ist eine Nickel-Basis-Superlegierung für Einkristalle offenbart. Die Superlegierung weist in Gewichtsprozent folgende Zusammensetzung auf: 6-15 % Chrom, 5-12 % Wolfram, 0,01-4 % Rhenium, 3-9 % Tantal, 0,5-2 % Titan, 4-7 % Aluminium und optional 0,5-3 % Molybdän. Mit dieser Superlegierung wird sowohl eine Hochtemperaturrißfestigkeit als auch eine Korrosionsbeständigkeit erreicht. Um die Korrosionsbeständigkeit nicht zu beeinträchtigen, darf der Titangehalt zwei Gewichtsprozent nicht überschreiten.

In der US-PS-5,122,206 ist eine Nickel-Basis-Superlegierung angegeben, die eine besonders schmale Koexistenzzone für die feste und flüssige Phase aufweist und damit besonders für einen Einkristallgießprozeß geeignet ist. Die Legierung weist in Gewichtsprozent folgende Zusammensetzung auf: 10-30 % Chrom, 0,1-5 % Niob, 0,1-8 % Titan, 0,1-8 % Aluminium, 0,05-0,5 % Kupfer oder statt Kupfer 0,1-3 % Tantal, wobei im erstgenannten Fall optional auch Hafnium oder Rhenium mit einem Gehalt von 0,05-3 % vorhanden sein kann und im zweiten Fall auch statt Rhenium oder Hafnium 0,05-0,5 % Kupfer. Weiterhin können optional 0,05-3 % Molybdän oder Wolfram vorgesehen sein.

Der Erfindung liegt die Aufgabe zugrunde, ein Bauteil aus einer Nickel-Basis-Superlegierung anzugeben, das besonders günstige Eigenschaften hinsichtlich einer Hochtemperaturfestigkeit, Oxidations- und Korrosionsbeständigkeit und Stabilität gegen duktilitätsmindernde Bildung intermetallischer Phasen aufweist. Weitere Aufgabe der Erfindung ist die Angabe eines Herstellungsverfahrens für ein solches Bauteil.

Erfindungsgemäß wird die auf ein Bauteil gerichtete Aufgabe gelöst durch Angabe eines hochtemperaturbeständigen Bauteils aus einer Nickel-Basis-Superlegierung, deren Zusammensetzung folgende Elemente in Gewichtsprozent umfaßt:
11-13 % Chrom,
3-5 % Wolfram,
0,5-2,5 % Molybdän,
3-5 % Aluminium,
3-5 % Titan,
3-7 % Tantal,
1-5 % Rhenium,
Rest Nickel und Verunreinigungen.

Die Superlegierung des angegebenen Bauteils ist in ihrer Zusammensetzung erstmalig so spezifiziert, daß für das Bauteil besonders günstige Eigenschaften hinsichtlich seiner Hochtemperaturfestigkeit, seiner Oxidations- und Korrosionsbeständigkeit und hinsichtlich einer Stabilität gegen die Bildung duktilitätsmindernder intermetallischer Phasen besteht. Über umfangreiche Versuche, die der Erfindung vorausgingen, konnte die angegebene spezielle Zusammensetzung ermittelt werden, mit der die gewünschten, oben genannten Eigenschaften in überraschend hohem Maße erfüllt werden. Insbesondere geht die Erfindung dabei von einer chromreichen Superlegierung aus, die eine erhöhte Festigkeit durch den Zusatz von Rhenium erhält. Die durch Rhenium geförderte Bildung versprödender intermetallischer Phasen wird durch die subtil ausbalancierte Zusammensetzung mit den anderen Elementen kontrolliert.

Vorzugsweise beträgt der Rheniumgehalt mindestens zwei Gewichtsprozent.

Bevorzugt enthält die Super-Legierung Ruthenium. Durch die Zugabe von Ruthenium kann insbesondere die Tendenz zur Ausbildung versprödender intermetallischer Phasen weiter verringert werden. Gerade bei einem Rheniumgehalt oberhalb von zwei Gewichtsprozent erweist sich die Zugabe von Ruthenium als günstig. Vorzugsweise ist dabei der maximale Rutheniumgehalt drei Gewichtsprozent und der minimale Rutheniumgehalt 0,1 Gewichtsprozent Gewichtsprozent.

Bevorzugtermaßen liegt der Kobaltgehalt der Superlegierung bei bis zu 12 Gewichtsprozent.

Vorzugsweise enthält die Superlegierung höchstens ein Gewichtsprozent Niob.

Bevorzugtermaßen ist in der Superlegierung optional mindestens eines der folgenden Elemente enthalten:
0-2 Gew.-% Hafnium,
0-1 Gew.-% Zirkon,
0-0,05 Gew.-% Bor,
0-0,2 Gew.-% Kohlenstoff.

Erfindungsgemäß wird die auf ein Bauteil gerichtete Aufgabe ebenso gelöst durch Angabe eines hochtemperaturbeständigen Bauteils aus einer Nickel-Basis-Superlegierung, deren Zusammensetzung folgende Elemente in Gewichtsprozent umfaßt:
11-13 % Chrom,
3-5 % Wolfram,
0,5-2,5 % Molybdän,
3-5 % Aluminium,
3-5 % Titan,
3-7 % Tantal,
0,1-5 % Ruthenium,
Rest Nickel und Verunreinigungen.

Die Vorteile für ein solches Bauteil ergeben sich entsprechend den obigen Ausführungen zu den Vorteilen des Rhenium aufweisenden Bauteils. Überraschenderweise läßt sich auch durch Zugabe von Ruthenium und ohne einen Rheniumgehalt eine besonders hohe Hochtemperaturfestigkeit erreichen, wobei in der angegebenen Zusammensetzung gleichzeitig die Oxidations/Korrosionsbeständigkeit ebenfalls hoch ist.

Bevorzugtermaßen ist der Kobaltgehalt der Superlegierung geringer als 12 Gewichtsprozent, während der Niobgehalt bei höchstens einem Gewichtsprozent liegt. Vorzugsweise sind in der Superlegierung 0-2 Gewichtsprozent Hafnium und/oder 0-1 Gewichtsprozent Zirkon und/oder 0-0,05 Gewichtsprozent Bor und/oder 0-0,2 Gewichtsprozent Kohlenstoff enthalten.

Vorzugsweise weist das Bauteil eine gerichtet erstarrte Kornstruktur auf. In einer solchen gerichtet erstarrten Struktur sind die Korngrenzen im wesentlichen entlang einer Achse ausgerichtet. Damit ergibt sich eine besonders hohe Festigkeit entlang dieser Achse.

Bevorzugtermaßen weist das Bauteil eine einkristalline Struktur auf. Durch die einkristalline Struktur werden festigkeitsmindernde Korngrenzen im Bauteil vermieden und es ergibt sich eine besonders hohe Festigkeit.

Vorzugsweise ist das Bauteil als eine Gasturbinenschaufel ausgebildet. Gerade eine Gasturbinenschaufel ist besonders hohen Anforderungen hinsichtlich einer Hochtemperaturfestigkeit und einer Oxidations-/Korrosionsbeständigkeit ausgesetzt.

Erfindungsgemäß wird die auf ein Verfahren gerichtete Aufgabe gelöst durch Angabe eines Verfahrens zur Herstellung eines Bauteils aus einer Superlegierung gemäß der obigen Ausführungen mittels eines konventionellen Gießprozesses. In einem solchen konventionellen Gießprozeß wird eine feinkörnige Feingußstruktur für das Bauteil erzielt. Dieser Gießprozeß ist besonders kostengünstig.

Die auf ein Verfahren gerichtete Aufgabe wird ebenso gelöst durch ein Verfahren zur Herstellung eines Bauteils aus einer Superlegierung mit der obengenannten Zusammensetzung bei dem die Superlegierung so abgekühlt wird, daß sie gerichtet oder einkristallin erstarrt, wobei die Abkühlung im Vakuum durch ein flüssiges Kühlmetall erfolgt. Ein solcher, als Liquid Metal Cooling bezeichneter Prozeß verbessert erheblich die Qualität und Geschwindigkeit des Gießprozesses. Gerade im Vakuum erfolgt eine Abkühlung nur durch Abstrahlung. Die Kühlleistung wird erheblich durch ein flüssiges Kühlmetall erhöht. Damit kann der Erstarrungsprozeß, bei dem das zu erstarrende Bauteil entlang einer Bauteilachse abgekühlt wird, für eine möglichst fehlerfreie und zügige Erstarrung optimiert werden.

Die Erfindung wird in einem Ausführungsbeispiel anhand der Zeichnung näher erläutert. Es zeigen:
- FIG 1: eine Gasturbinenschaufel
- FIG 2: ein Verfahren zur Herstellung einer Gasturbinenschaufel,
- FIG 3: Legierungszusammensetzungen

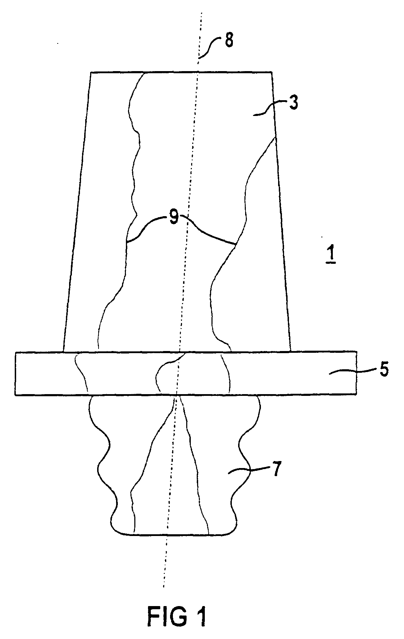

FIG 1 zeigt in einer Ansicht ein hochtemperaturbeständiges Bauteil, ausgeführt als Gasturbinenschaufel 1. Die Gasturbinenschaufel 1 weist ein Schaufelblatt 3, eine Plattform 5 und einen Befestigungsbereich 7 auf. Die Gasturbinenschaufel 1 ist in einem Gießprozeß gerichtet erstarrt hergestellt, wodurch sich entlang einer Schaufelachse 8 gerichtete Korngrenzen 9 ergeben.

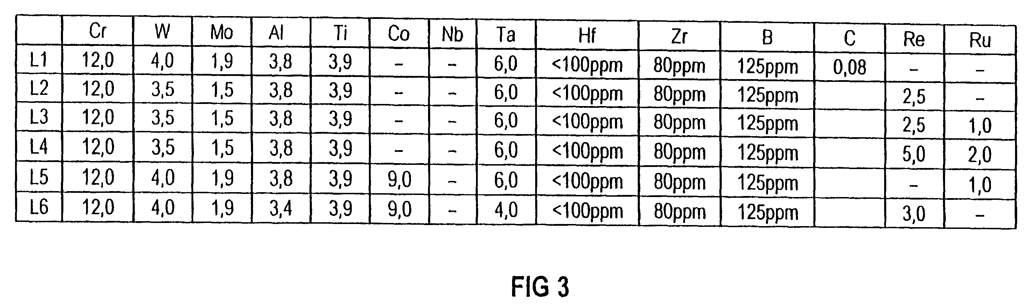

Die Gasturbinenschaufel 1 ist aus einer Nickel-Basis-Superlegierung gefertigt, die eine der Zusammensetzungen aufweist, die in Tabelle 1 aufgeführt sind. Tabelle 1 (siehe FIG 3) enthält für sechs verschiedene Legierungen L1-L6 in jeder Spalte für ein Element die Gehaltsangabe im Gewichtsprozent. Der zu 100 % ergänzende Rest ist Nickel und unvermeidliche Verunreinigungen.

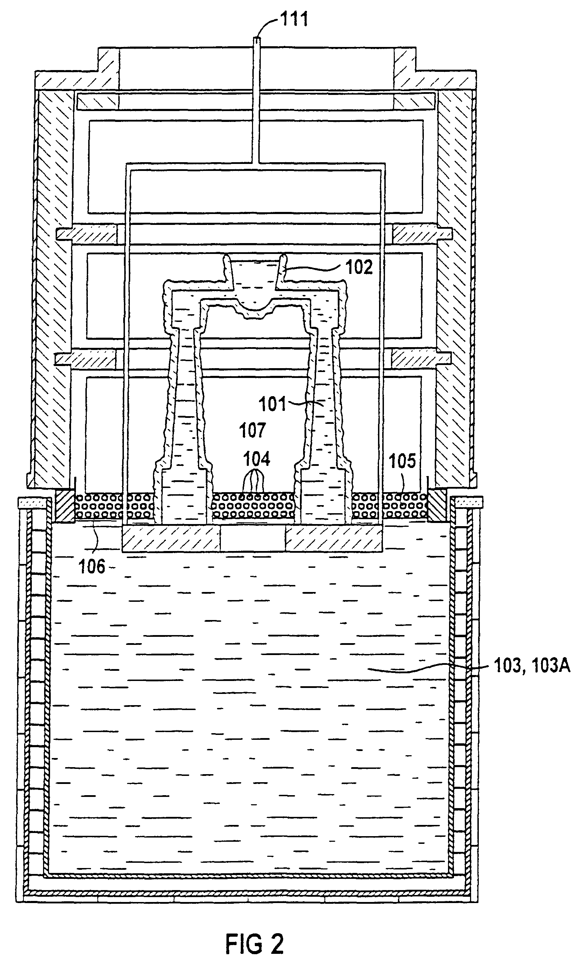

FIG 2 zeigt eine Schmelze 101 eines Metalls, insbesondere einer Superlegierung zur Herstellung von Turbinenschaufeln 1 in einer Gießform 102, welche zum Zwecke der Abkühlung in ein Bad 103 eines flüssigen Kühlmediums, vorzugsweise Zinn, ein anorganisches Salz oder Boroxid, einzutauchen ist. Das flüssige Kühlmedium 103a befindet sich auf einer zweiten Temperatur, die geringer ist als die erste Temperatur der Schmelze 101. Das Bad 103 ist abgedeckt von einer Deckschicht 104, die aus einem fließfähigen, wärmeisolierenden Schüttgut aus kugelförmigen Festkörpern 105, 106 (Hohlkugeln 105, Vollkugeln 106) abgedeckt ist. Die Hohlkugeln 105 bestehen vorzugsweise aus einem keramischen Werkstoff, wie Siliciumdioxid-Aluminiumoxid (Mullit). Die Vollkugeln 106 bestehen vorzugsweise aus einem Werkstoff wie Aluminiumoxid, Magnesiumoxid oder Zirkonoxid. Festkörper aus einem Vollmaterial können beispielsweise auch aus Pulverteilchen 106 eines marktgängigen Pulvers bestehen. Die Deckschicht 104 reduziert deutlich einen Wärmeeintrag aus der Heizzone 107, in der die Gießform 102 mit der Schmelze 101 zunächst gehalten wird, in das Bad 103. Die Gießform 102 befindet sich in der Heizzone 107 auf einer sehr hohen ersten Temperatur, insbesondere 1600 °C. Im Inneren der Deckschicht 104 bildet sich ein hohes Temperaturgefälle, entsprechend einem besonders hohen Temperaturgradienten aus. Aufgrund des Wärmeeintrags in die Schmelze 101 und die Gießform 102 nach Heizzone 107, und aufgrund des Wärmeaustrags aus der Schmelze 101 und der Gießform 102 in dem Bad 103, stellt sich in der Schmelze 101 in dem Bereich, wo die Gießform 102 die Deckschicht 104 durchquert, ebenfalls ein hoher Temperaturgradient ein. Durch einen solchen hohen Temperaturgradienten wird ein gerichtetes Erstarren der Schmelze 101 zu einem Werkstück oder mehreren Werkstücken, insbesondere einer Turbinenschaufel 1 mit stengelkristallinem oder einkristallinem Gefüge bewirkt. Die Gießform 102 ist über ein Haltegestell 111 in das Bad 103 verfahrbar.

Besonders bevorzugte Legierungen weisen folgende Zusammensetzung auf:

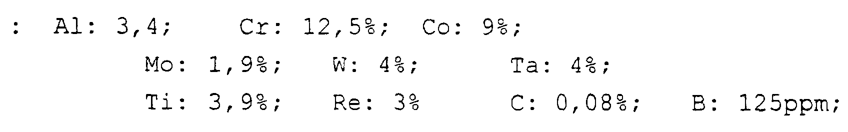

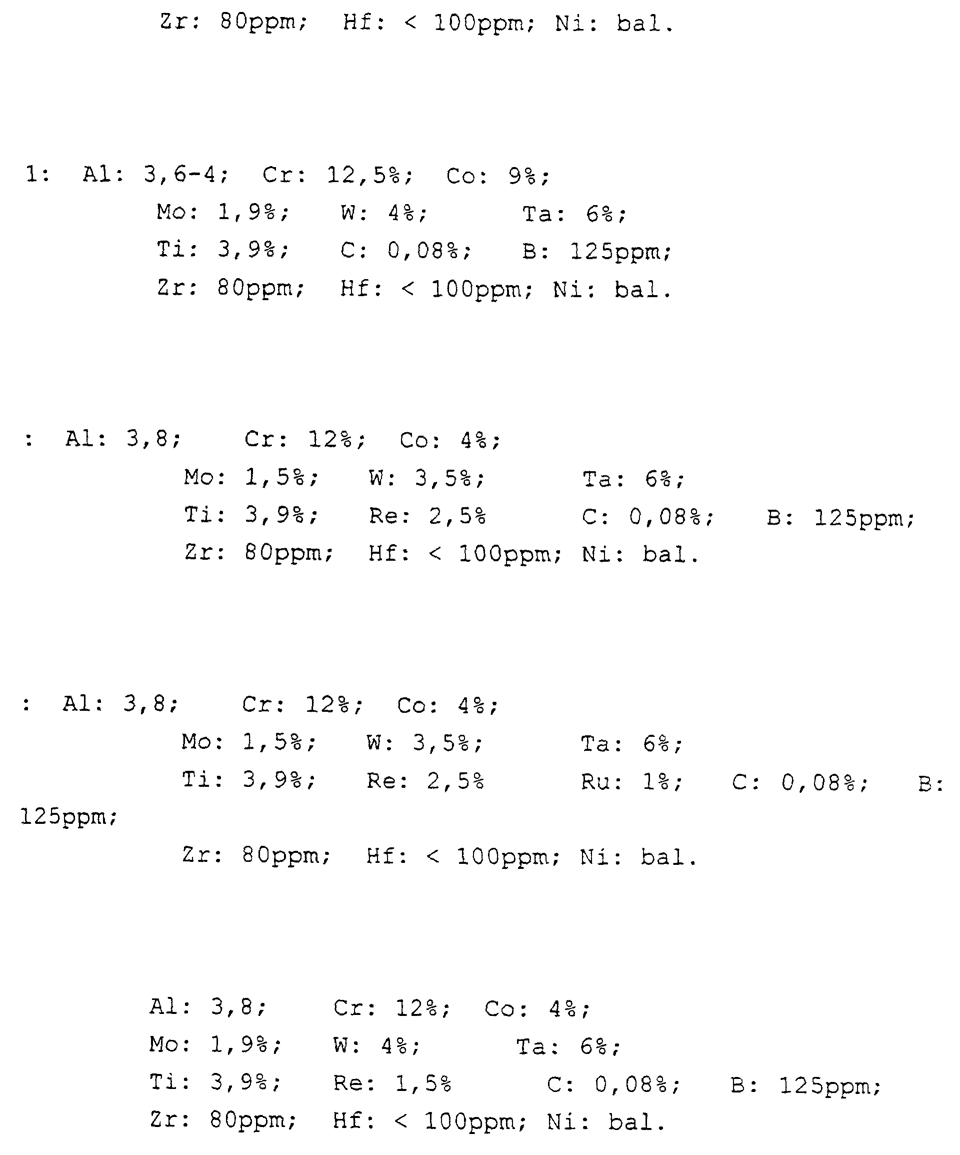

## Patentansprüche

1. Hochtemperaturbeständiges Bauteil (1) aus einer Nickel-Basis-Superlegierung, deren Zuammensetzung folgende Elemente in Gewichtsprozent umfaßt:
| | |
|---|---|
| 11 -13 % | Chrom |
| 3 - 5 % | Wolfram |
| 0,5-2,5 % | Molybdän |
| 3 - 5 % | Aluminium |
| 3 - 5 % | Titan |
| 3 - 7 % | Tantal |
| 0 - 12 % | Kobalt |
| 0 - 1 % | Niob |
| 0 - 2 % | Hafnium |
| 0 - 1 % | Zirkon |
| 0 - 0.05 % | Bor |
| 0 - 0.2 % | Kohlenstoff |
| 1 - 5 % | Rhenium |
| 0 - 5 % | Ruthenium |
Rest Ni und Verunreinigungen.

2. Bauteil (1) nach Anspruch 1, bei dem der Rhenium-Gehalt mindestens zwei Gewichtsprozent beträgt.

3. Bauteil (1) nach Anspruch 1, mit einem maximalen Ruthenium-Gehalt der Superlegierung von 3 Gewichtsprozent.

4. Bauteil (1) nach Anspruch 1 oder 3, mit einem minimalen Ruthenium-Gehalt der Superlegierung von 0,1 Gewichtsprozent, insbesondere 0,5 Gewichtsprozent.

5. Hochtemperaturbeständiges Bauteil (1) aus einer Nickel-Basis-Superlegierung, deren Zuammensetzung folgende Elemente in Gewichtsprozent umfaßt:
| | |
|---|---|
| 11 -13 % | Chrom |
| 3 - 5 % | Wolfram |
| 0,5-2,5 % | Molybdän |
| 3 - 5 % | Aluminium |
| 3 - 5 % | Titan |
| 3 - 7 % | Tantal |
| 0 - 12 % | Kobalt |
| 0 - 1 % | Niob |
| 0 - 2 % | Hafnium |
| 0 - 1 % | Zirkon |
| 0 - 0.05 % | Bor |
| 0 - 0.2 % | Kohlenstoff |
| 0.1 - 5 % | Ruthenium |
Rest Ni und Verunreinigungen.

6. Bauteil (1) nach einem der vorhergehenden Ansprüche, das eine gerichtet erstarrte Kornstruktur (9) aufweist.

7. Bauteil (1) nach einem der Ansprüche 1 bis 5, das eine einkristalline Struktur aufweist.

8. Bauteil (1) nach einem der Ansprüche 1 bis 5, das eine isotrope Verteilung der Orientierungen der Kornstruktur aufweist.

9. Bauteil (1) nach einem der vorhergehenden Ansprüche, das als Gasturbinenschaufel ausgebildet ist.

10. Verfahren zur Herstellung eines in einem der vorhergehenden Ansprüche angegebenen Bauteils (1) durch Gießen mittels eines konventionellen Gießprozesses.

11. Verfahren zur Herstellung eines in einem der Ansprüche 1 bis 9 angegebenen Bauteils (1), bei dem die Superlegierung so abgekühlt wird, daß sie gerichtet oder einkristallin erstarrt, wobei die Abkühlung im Vakuum durch ein flüssiges Kühlmetall oder durch ein flüssiges, anorganisches Salz erfolgt.

## Claims

1. High-temperature-resistant component (1) made from a nickel-base superalloy, the composition of which comprises the following elements, in percent by weight:
| | |
|---|---|
| 11-13 % | chromium |
| 3-5 % | tungsten |
| 0.5-2.5 % | molybdenum |
| 3-5 % | aluminium |
| 3-5 % | titanium |
| 3-7 % | tantalum |
| 0-12 % | cobalt |
| 0-1 % | niobium |
| 0-2 % | hafnium |
| 0-1 % | zirconium |
| 0-0.05 % | boron |
| 0-0.2 % | carbon |
| 1-5 % | rhenium |
| 0-5 % | ruthenium |
remainder Ni and impurities.

2. Component (1) according to Claim 1, in which the rhenium content is at least 2% by weight.

3. Component (1) according to Claim 1, having a maximum ruthenium content in the superalloy of 3% by weight.

4. Component (1) according to Claim 1 or 3, having a minimum ruthenium content in the superalloy of 0.1% by weight, in particular 0.5% by weight.

5. High-temperature-resistant component (1) made from a nickel-base superalloy, the composition of which comprises the following elements, in percent by weight:
| | |
|---|---|
| 11-13 % | chromium |
| 3-5 % | tungsten |
| 0.5-2.5 % | molybdenum |
| 3-5 % | aluminium |
| 3-5 % | titanium |
| 3-7 % | tantalum |
| 0-12 % | cobalt |
| 0-1 % | niobium |
| 0-2 % | hafnium |
| 0-1 % | zirconium |
| 0-0.05 % | boron |
| 0-0.2 % | carbon |
| 0.1-5 % | ruthenium |
remainder Ni and impurities.

6. Component (1) according to one of the preceding claims, which has a directionally solidified grain structure (9).

7. Component (1) according to one of Claims 1 to 5, which has a monocrystalline structure.

8. Component (1) according to one of Claims 1 to 5, which has an isotropic distribution of the orientations of the grain structure.

9. Component (1) according to one of the preceding claims, which is designed as a gas turbine blade.

10. Process for producing a component (1) described in one of the preceding claims by casting by means of a conventional casting process.

11. Process for producing a component (1) described in one of Claims 1 to 9, in which the superalloy is cooled in such a way that it solidifies directionally or in monocrystalline form, the cooling taking place in vacuo by means of a liquid cooling metal or by means of a liquid inorganic salt.

## Revendications

1. Pièce (1) résistant à des températures hautes en un superalliage à base de nickel dont la composition comprend des éléments suivants en pourcentage en poids :
| | |
|---|---|
| 11 à 13 % | de chrome |
| 3 à 5 % | de tungstène |
| 0,5 à 2,5 % | de molybdène |
| 3 à 5 % | d'aluminium |
| 3 à 5 % | de titane |
| 3 à 7 % | de tantale |
| 0 à 12 % | de cobalt |
| 0 à 1 % | de niobium |
| 0 à 2 % | d'hafnium |
| 0 à 1 % | de zirconium |
| 0 à 0,05 % | de bore |
| 0 à 0,2 % | de carbone |
| 1 à 5 % | de rhénium |
| 0 à 5 % | de ruthénium |
le solde étant du nickel et des impuretés.

2. Pièce (1) suivant la revendication 1, dans laquelle la teneur en rhénium est d'au moins 2 % en poids.

3. Pièce (1) suivant la revendication 1 ayant une teneur maximum en ruthénium du superalliage de 3 % en poids.

4. Pièce (1) suivant la revendication 1 ou 3, ayant une teneur minimum en ruthénium du superalliage de 0,1 % en poids, notamment de 0,5 % en poids.

5. Pièce (1) résistant aux températures hautes en un superalliage de nickel dont la composition comprend des éléments suivants en pourcentage en poids :
| | |
|---|---|
| 11 à 13 % | de chrome |
| 3 à 5 % | de tungstène |
| 0,5 à 2,5 % | de molybdène |
| 3 à 5 % | d'aluminium |
| 3 à 5 % | de titane |
| 3 à 7 % | de tantale |
| 0 à 12 % | de cobalt |
| 0 à 1 % | de niobium |
| 0 à 2 % | d'hafnium |
| 0 à 1 % | de zirconium |
| 0 à 0,05 % | de bore |
| 0 à 0,2 % | de carbone |
| 0,1 à 5 % | de ruthénium |
le solde étant du Ni et des impuretés.

6. Pièce (1) suivant l'une des revendications précédentes, qui a une structure (9) de grain à solidification dirigée.

7. Pièce (1) suivant l'une des revendications 1 à 5, qui a une structure monocristalline.

8. Pièce (1) suivant l'une des revendications 1 à 5, qui a une répartition isotrope des orientations de la structure de grain.

9. Pièce (1) suivant l'une des revendications précédentes, qui est constituée sous la forme d'une aube de turbine à gaz.

10. Procédé de production d'une pièce (1) indiquée dans l'une des revendications précédentes par coulée au moyen d'une opération habituelle de coulée.

11. Procédé de production d'une pièce (1) mentionnée dans l'une des revendications 1 à 9, dans lequel on refroidit le superalliage de manière à ce qu'il se solidifie de façon dirigée monocristalline, le refroidissement s'effectuant sous vide par un métal liquide de refroidissement ou par un sel minéral liquide.
